# EUROPÄISCHE PATENTANMELDUNG

(11) **EP 1 304 309 A2**
(43) Veröffentlichungstag der Anmeldung: **23.04.2003**
(21) Anmeldenummer: 02022146.1
(22) Anmeldetag: 02.10.2002
(51) Int. Cl.: B81B 3/00

(54) **Verfahren zum Herstellen eines mikromechanischen Bauelements mit einer beweglichen Struktur**

(30) Priorität: 17.10.2001 DE 10151130
(71) Anmelder: Infineon Technologies AG, 81669 München (DE)
(72) Erfinder: Aigner, Robert, 81675 München (DE); Kapels, Hergen, 85579 Neubiberg (DE); Meckes, Andreas, 81735 München (DE); Oppermann, Klaus-Günter, 83607 München (DE)
(74) Vertreter: Schoppe, Fritz, Dipl.-Ing.

(57) **Zusammenfassung**

Bei einem Verfahren zum Herstellen eines mikromechanischen Bauteils (9) mit einer beweglichen Struktur (3) wird ein Sticken der beweglichen Struktur (3) vermieden, in dem die bewegliche Struktur teilweise mit Fotolack fixiert wird, bevor die bewegliche Struktur freigeätzt wird. In einem Über-Kritischer-Punkt-Trockner wird der Fotolack mit einem organischen Lösungsmittel entfernt, welches anschließend durch CO₂ verdrängt und gelöst wird. Durch Erhöhen der Temperatur des Trockners (11) über den kritischen Punkt des CO₂ wird das Bauteil (9) getrocknet, ohne daß ein Sticken auftreten kann.

## Beschreibung

Verfahren zum Herstellen eines mikromechanischen Bauteils mit einer beweglichen Struktur

Die vorliegende Erfindung befaßt sich mit einem Verfahren zum Herstellen eines mikromechanischen Bauteils mit einer beweglichen Struktur.

Insbesondere befaßt sich die vorliegende Erfindung mit einem Herstellverfahren für ein mikromechanisches Bauteil mit einer beweglichen Struktur, bei dem das Klebenbleiben (sticking) der beweglichen Struktur an feststehenden Bereichen des mikromechanischen Bauteils verhindert wird.

Es ist ein seit langem bekanntes Problem bei der Herstellung mikromechanischer Sensoren und Aktoren, daß es bei dem naßchemischen Freilegen beweglicher Strukturen zu einem Klebenbleiben der beweglichen Struktur an unmittelbar benachbarten feststehenden Bereiche des mikromechanischen Bauteils kommen kann, wenn nach dem ätztechnischen Strukturieren des beweglichen Bauteils die Ätzflüssigkeit zunächst mit einer Spülflüssigkeit entfernt wird und anschließend abgetrocknet wird. Während dieses Abtrocknens kann es zu einer Annäherung des beweglichen Bauteils und infolge hiervon zum Ankleben des beweglichen Bauteils an unmittelbar benachbarten feststehenden Bereichen des Bauteils kommen.

Bei bekannten Verfahren werden mikromechanische Strukturen durch Freiätzen einer aus Siliziumdioxid bestehenden Opferschicht mit Flußsäure freigelegt, anschließend mit Wasser und Aceton gespült und anschließend mit einem Trocknungsgerät getrocknet, das als "Über-Kritischer-Punkt-Trockner" (SCPD = Super critical point drier) bezeichnet wird. Bei diesem bekannten Verfahren läßt sich das Aceton sehr gut durch CO₂ entfernen, woraufhin das CO₂ in dem "Über-Kritischer-Punkt-Trockner" durch reine Temperaturerhöhung jenseits der kritischen Temperatur in die gasförmige Phase überführt wird, wodurch dieser Prozeß trockene, bewegliche Strukturen liefert. Jedoch ist die Verwendung eines solchen Prozesses in einer standardmäßigen CMOS-Umgebung nicht möglich, da die Strukturen und damit die Wafer bis zu ihrer Trocknung im "Über-Kritischer-Punkt-Trockner" nicht trocken werden dürften, da es ansonsten bereits zwischenzeitlich zu einem Ankleben (sticking) der beweglichen Strukturen kommt.

In der Veröffentlichung von D. Kobayashi et al. In Jpn. J. Appl. Phys. 32, Part 2, No. 11A, L1642 bis L1644 (1993) ist ein Verfahren beschrieben, mit dessen Hilfe bewegliche Mikrostrukturen freigeätzt werden können, ohne daß das Problem des Sticking auftritt. Bisherige Verfahren, bei denen eine Spülflüssigkeit zunächst verfestigt und dann durch Sublimation entfernt wird, oder bei denen die Spülflüssigkeit oberhalb des kritischen Punktes erhitzt wird, sind in der Einleitung dieser Veröffentlichung erwähnt. Als Alternative dazu geben die Autoren an, die beweglichen Strukturen vor dem Freiätzen in Fotolack einzubetten und nach dem lateralen Freiätzen der von Anteilen dieses Fotolackes gehaltenen Strukturen den Fotolack durch Veraschen zu entfernen.

Weiche Strukturen, die mit einem Lackstöpsel fixiert wurden, sticken aber nach dem Lackveraschen im Plasma, da durch die exotherme Reaktion zwischen Sauerstoff und Fotolack der Fotolack zähflüssig wird und somit die Struktur zum Sticken bringt.

Aus der DE 19506404 C1 ist ein weiteres Verfahren zum Herstellen einer mikromechanischen Komponente mit einem beweglichen Teil bekannt, bei dem das Klebenbleiben des beweglichen Teils an einer benachbarten Oberfläche verhindert werden soll. Bei diesem Verfahren erfolgt sowohl das Ätzen zum Strukturieren und Separieren der mikromechanischen Komponente als auch die nachfolgende Dehydrierung und Trocknung in demselben Behälter. Die mikromechanische Komponente wird in dem Behälter mit deionisiertem Wasser gespült, um das Ätzmittel vollständig zu entfernen, woraufhin der Behälter mit Aceton oder Ethanol durchspült wird, sodann das Aceton oder Ethanol durch flüssiges Kohlendioxid verdrängt wird, wobei in einem abschließenden Schritt der Behälter auf einen Temperaturwert oberhalb der kritischen Temperatur von Kohlendioxid erwärmt wird, um das Kohlendioxid in die gasförmige Phase zu überführen. Abschließend wird das gasförmige Kohlendioxid aus dem Behälter langsam abgelassen. Anschließend wird das getrocknete Bauelement aus dem Behälter entnommen.

Wie auch das eingangs diskutierte Verfahren nach dem Stand der Technik ist auch dieses Verfahren in seinem Anwendungsbereich beschränkt, da es verhindert werden muß, daß die mikromechanische Komponente zwischen dem Ätzschritt und dem abschließenden Schritt des Verdampfens des Kohlendioxids trocken wird, da sonst deren bewegliche Struktur festklebt. Somit eignet sich dieses bekannte Verfahren nicht zur Herstellung in einem standardmäßigen CMOS-Prozess.

Aus der EP 0783107 A1 ist ein Herstellungsverfahren für ein mikromechanisches Bauteil mit einer beweglichen Struktur bekannt, bei dem zur Vermeidung von Sticking-Effekten vor der Freilegung der beweglichen mikromechanischen Struktur im Wege eines Ätzprozesses diese über eine Hilfsstruktur, die aus einem Fotolack besteht, gegenüber dem Substrat fixiert wird, woraufhin die bewegliche Struktur durch einen weiteren Ätzschritt freigelegt wird. Abschließend wird die Fotolackfixierung mit Hilfe eines O2-Plasmas oder eines Trockenätzprozesses entfernt, wodurch die Struktur beweglich wird. Beides sind exotherme Vorgänge so dass auch dieses Verfahren den gleichen Beschränkungen unterworfen ist, an denen auch das oben diskutierte bekannte Verfahren von D. Kabayashi et. al leidet.

Ausgehend von diesem Stand der Technik liegt der vorliegenden Erfindung die Aufgabe zugrunde, ein Verfahren zum Herstellen eines mikromechanischen Bauteils mit einer beweglichen Struktur zu schaffen, bei dem ein Sticken der beweglichen Struktur an feststehenden Bereichen des Bauteils vermieden wird, obgleich das Verfahren nicht die Beschränkungen der Herstellungsprozeßabläufe bekannter Verfahren mit sich bringt.

Diese Aufgabe wird durch ein Verfahren nach Anspruch 1 gelöst.

Ausgangspunkt des erfindungsgemäßen Verfahrens ist ein vorprozessiertes mikromechanisches Bauteil, bei dem eine Struktur in eine später zu entfernende Schicht eingebettet ist.

In einem ersten Verfahrensschritt erfolgt beispielsweise durch ein ätztechnisches Verfahren ein teilweises Freilegen der eingebetteten Struktur, um eine Ausnehmung in der Schicht zu erzeugen, die zumindest an die Struktur und an einen feststehenden Bereich des Bauteils, wie beispielsweise das Substrat, heranreicht.

In einem zweiten Verfahrensschritt erfolgt ein Fixieren der Struktur gegenüber dem feststehenden Bereich des Bauteils mittels eines Lackes.

In einem dritten Verfahrensschritt wird die verbliebene Schicht zumindest im Bereich der beweglichen Struktur derart beispielsweise mittels eines ätztechnischen Verfahrens entfernt, daß die bewegliche Struktur nur noch von dem Lack gegenüber dem feststehenden Bereich fixiert ist.

In einem vierten Verfahrensschritt wird das zu prozessierende Bauteil in einen Rezipienten eingebracht.

In einem fünften Verfahrensschritt wird ein Lösungsmittel in den Rezipienten eingeführt, um den Lack zu entfernen.

In einem darauf folgenden sechsten Verfahrensschritt wird eine Flüssigkeit, in der dieses Lösungsmittel löslich ist, in den Rezipienten eingeführt.

In einem siebten Verfahrensschritt wird der Rezipient über die kritische Temperatur der Flüssigkeit erwärmt, um diese in die gasförmige Phase zu überführen, bevor in einem achten Verfahrensschritt das Gas mit dem gelösten Lösungsmittel aus dem Rezipienten abgelassen wird.

Ein bevorzugtes Ausführungsbeispiel des erfindungsgemäßen Verfahrens wird nachfolgend unter Bezugnahme auf die beiliegenden Zeichnungen näher erläutert. Es zeigen:
Die Figuren 1 bis 3 sowie 5 und 6 Querschnittsdarstellungen durch ein mikromechanisches Bauteil nach Durchführung unterschiedlicher Prozeßschritte zu dessen Herstellung; und
Figur 4 eine Querschnittsdarstellung durch einen Über-Kritische-Temperatur-Trockner.

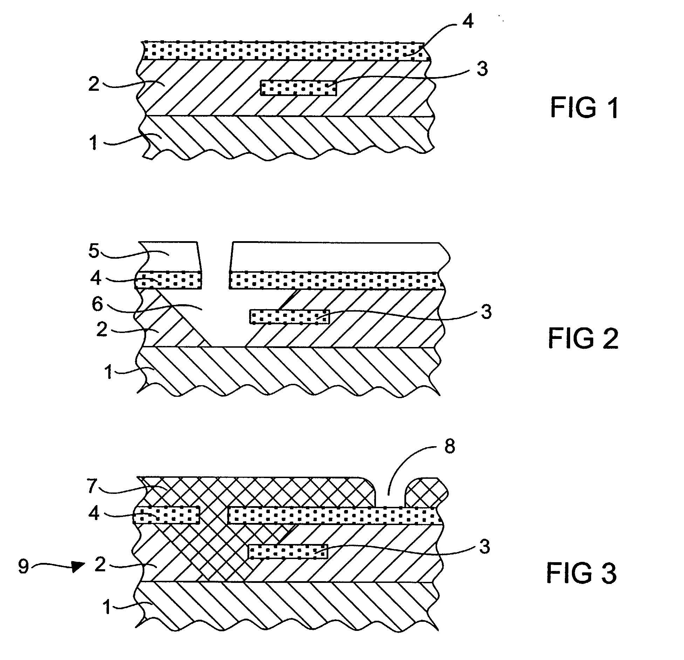

Figur 1 zeigt einen Ausschnitt eines oberflächennahen Bereiches eines Siliziumsubstrates 1, auf dem eine Siliziumdioxid-Schicht 2 angeordnet ist, innerhalb der die im Laufe des zu beschreibenden Verfahrens freizulegende, später bewegliche Struktur 3 eingebettet ist. Die bewegliche Struktur 3 besteht üblicherweise aus Polysilizium, kann jedoch auch aus anderen Materialien bestehen. Die Siliziumdioxid-Schicht wird von einer aus Polysilizium bestehenden oberen Schicht 4 abgedeckt. Mittels einer strukturierten Fotomaske 5 wird, wie dies in Figur 2 verdeutlicht wird, eine Ausnehmung 6 mittels ätztechnischer Verfahren in der oberen Schicht 4 und der Siliziumdioxid-Schicht 2 erzeugt, welche die bewegliche Struktur 3 teilweise freilegt und sich bis zu einem geeigneten feststehenden Bereich des Bauteils, wie im Ausführungsbeispiel dem Siliziumsubstrat 1 hin erstreckt. Je nach der gewünschten Form der Ausnehmung kommen sowohl isotrope als auch anisotrope Ätzverfahren in Betracht.

Wie in Figur 3 gezeigt ist, wird nach dem Entfernen der vorherigen Fotomaske 5 eine Fotolackschicht 7 auf die obere Schicht 4 aufgebracht, welche auch die Ausnehmung 6 vollständig verfüllt. Die gleichfalls noch in Figur 3 zu sehen ist, wird die Fotolackschicht 7 in einem zusätzlichen fotolithographischen Schritt strukturiert, so daß eine Öffnung 8 für weitere Ätzprozesse definiert wird.

In Abweichung von dem soeben beschriebenen bevorzugten Ausführungsbeispiel das Verfahrens können die Öffnungen in den Schicht 4 auch schon vor dem Aufbringen der Fotomaske 5 bzw. Fotolackschicht 7 gebildet sein.

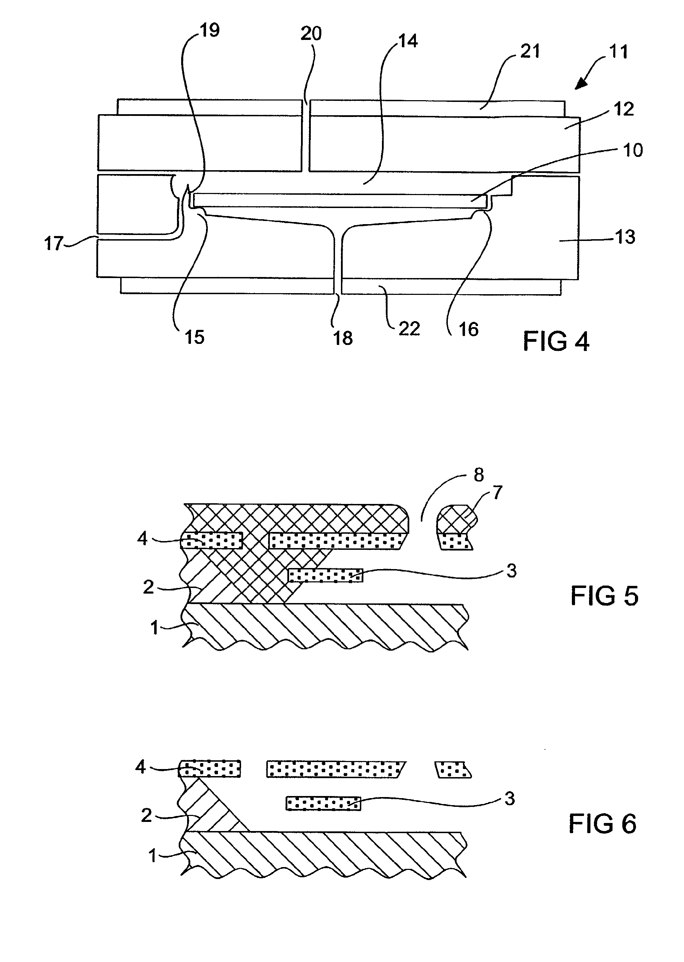

Nunmehr wird das soweit vorprozessierte Bauteil, das in seiner Gesamtheit mit dem Bezugszeichen 9 bezeichnet ist, und das Teil einer Siliziumwaferstruktur 10 ist, in einen Über-Kritischer-Punkt-Trockner eingebracht, der in Figur 4 in Querschnittsdarstellung gezeigt und in seiner Gesamtheit mit dem Bezugszeichen 11 bezeichnet ist.

Wie gleichfalls in Figur 4 zu sehen ist, umfaßt der Trockner 11 ein Druckgefäßdeckelteil 12 sowie ein Druckgefäßbodenteil 13, die miteinander einen Prozeßräum 14 festlegen, innerhalb dessen die Siliziumwaferstruktur 10 auf angepaßten Auflagebereichen 15, 16 gehalten wird. Innerhalb des Druckgefäßbodenteiles 13 sind ein Zulauf 17 und ein Ablauf 18 ausgebildet. Am Ende des Zulaufes 17 zum Prozeßraum 14 ist ein Prallblech 19 angeordnet, um die durch den Zulauf 17 in den Prozeßraum 14 eingeführten Medien von der Siliziumwaferstruktur 10 fortzulenken.

Wie in Figur 5 gezeigt ist, folgt auf die Strukturierung der Öffnung 8 in der Fotolackschicht 7 ein Fortätzen zumindest eines Teils der verbliebenen Schicht 2 im Bereich der beweglichen Struktur 3 derart, daß die bewegliche Struktur 3 gegenüber dem Siliziumsubstrat 1 nur noch durch die Fotolackstruktur 7 fixiert ist. Dieser Ätzschritt kann sowohl vor Einbringen des Bauteils 9 in den Trockner 11 als auch nach dem Einbringen des Bauteils 9 in den Trockner 11 erfolgen, soweit die Materialien des Trockners 11 gegenüber den verwendeten Ätzmaterialien resistent sind.

Zum Fertigprozessieren des in Figur 6 gezeigten Bauteils wird ein Lösungsmittel in den Prozeßraum 14 des Trockners 11 eingeführt, das zum Entfernen des Lackes 7 dient. Bevorzugt wird ein organisches Lösungsmittel, wie beispielsweise 2-Propanol eingesetzt, welches sowohl den Fotolack ablöst als auch selbst in CO₂ oder einer Halogen-Kohlenstoff-Verbindung löslich ist. Bevorzugt wird das erfindungsgemäße Verfahren mit CO₂ durchgeführt, welches durch den Zulauf 17 zugeführt wird, bis das organische Lösungsmittel im Prozeßraum 14 vollständig verdrängt und gelöst ist. Nunmehr werden der Zulauf 17, der Ablauf 18 und eine Deckelauslaßöffnung 20 geschlossen, bevor die Temperatur des Trockners 11 durch Heiz-Kühl-Platten 21, 22 an der Oberseite des Druckgefäßdeckelteils 12 und der Unterseite des Druckgefäßbodenteils 13 auf einen Wert oberhalb der kritischen Temperatur für CO₂, d.h. auf einen Wert oberhalb von 30,98 Grad C. angehoben wird. Falls statt CO₂ eine Halogen-Kohlenstoff-Verbindung wie Freon (CClF₃) eingesetzt wird, liegt die kritische Temperatur bei 29 Grad C.

Bei dieser Temperatur wird das zunächst flüssige CO₂ in seine gasförmige Phase überführt.

Nunmehr erfolgt ein langsames Ablassen des CO₂-Gases durch die Deckelauslaßöffnung 20, woraufhin nach Öffnen des Trockners 11 die fertigprozessierte Siliziumwaferstruktur 10 entnommen werden kann.

### Bezugszeichenliste

- 1: Siliziumsubstrat
- 2: Siliziumdioxidschicht
- 3: Bewegliche Struktur
- 4: Obere Schicht
- 5: Fotomaske
- 6: Ausnehmung
- 7: Fotolackschicht
- 8: Öffnung
- 9: Bauteil
- 10: Siliziumwaferstruktur
- 11: Über-Kritischer-Punkt-Trockner
- 12: Druckgefäßdeckelteil
- 13: Druckgefäßbodenteil
- 14: Prozessraum
- 15, 16: Auflagebereich
- 17: Zulauf
- 18: Ablauf
- 19: Prallblech
- 20: Deckelauslaßöffnung
- 21, 22: Heiz-Kühl-Platten

## Patentansprüche

1. Verfahren zum Herstellen eines mikromechanischen Bauteils (9) mit einer beweglichen Struktur (3), mit folgenden Schritten:
- Bereitstellen des mikromechanischen Bauteils (9) mit einer in eine Schicht (2) eingebetteten Struktur (3);
- teilweise Freiligen der eingebetteten Struktur (3) durch Erzeugen einer an die Struktur und an einen feststehenden Bereich des Bauteils (9) heranreichenden Ausnehmung (6) in der Schicht (2);
- Fixieren der Struktur (3) gegenüber dem feststehenden Bereich des Bauteils (9) mittels eines Lackes (7);
- Entfernen der verbliebenen Schicht (2) zumindest im Bereich der beweglichen Struktur (3) derart, daß die bewegliche Struktur (3) nur noch von dem Lack (7) gegenüber dem feststehenden Bereich fixiert ist;
- Einbringen des Bauteils (9) in einen Rezipienten (11);
- Einführen eines Lösungsmittels in den Rezipienten (11) zum Entfernen des Lackes (7);
- Einführen einer Flüssigkeit, in der das Lösungsmittel löslich ist, in den Rezipienten (11);
- Erwärmen des Rezipienten (11) über die kritische Temperatur der Flüssigkeit, um diese in ihre gasförmige Phase zu überführen; und
- Ablassen des Gases mit dem gelösten Lösungsmittel aus dem Rezipienten (11).

2. Verfahren nach Anspruch 1, bei dem die Schicht (2) aus Siliziumdioxid besteht und bei dem der Schritt des teilweisen Freilegens der eingebetteten Struktur (3) das teilweise Wegätzen der Schicht (2) umfaßt.

3. Verfahren nach Anspruch 1 oder 2, bei dem Lack ein Fotolack ist.

4. Verfahren nach Anspruch 3, bei dem das Lösungsmittel ein organisches Lösungsmittel ist.

5. Verfahren nach einem der Ansprüche 1 bis 4, bei dem die Flüssigkeit, die in die gasförmige Phase zu überführen ist, CO₂ ist.

6. Verfahren nach einem der Ansprüche 1 bis 4, bei dem die Flüssigkeit, die in die gasförmige Phase zu überführen ist, eine Halogen-Kohlenstoff-Verbindung ist.

7. Verfahren nach Anspruch 6, bei dem die Halogen-Kohlenstoff-Verbindung Freon CClF₃ ist.

8. Verfahren nach einem der Ansprüche 1 bis 7, bei dem der Rezipient ein sogenannter Über-Kritischer-Punkt-Trockner (11) ist.
